# EUROPÄISCHE PATENTSCHRIFT

(11) **EP 2 645 410 B1**
(45) Veröffentlichungstag und Bekanntmachung des Hinweises auf die Patenterteilung: **03.03.2021**
(21) Anmeldenummer: 13174234.8
(22) Anmeldetag: 05.10.2011
(51) Int. Cl.: H01L 21/67

(54) **Vorrichtung zur Prozessierung von Wafern**
Device for processing wafers
Dispositif de traitement de tranches de silicium

(30) Priorität: 15.10.2010 DE 102010048043
(43) Veröffentlichungstag der Anmeldung: 02.10.2013
(62) Teilanmeldung aus: 11764566.3
(73) Patentinhaber: EV Group GmbH, 4782 St. Florian am Inn (AT)
(72) Erfinder: Lindner, Paul, 4780 Schärding (AT); Hangweier, Peter-Oliver, 4742 Pram (AT)
(74) Vertreter: Schweiger, Johannes

(56) Entgegenhaltungen:
- WO-A1-2010/058481
- JP-A- 2001 351 892
- JP-A- 2010 212 638
- US-A- 5 455 082
- US-A1- 2003 003 767

## Beschreibung

Die Erfindung betrifft eine Vorrichtung zum Bonden von Substratpaaren, insbesondere Waferpaaren, gemäß Patentanspruch 1.

Prozessanlagen beziehungsweise -vorrichtungen der Halbleitertechnologie sind meist modular aufgebaut. Sie bestehen üblicherweise aus unterschiedlichen Kammern, in denen verschiedene Prozessschritte durchgeführt werden. So kommen beispielsweise zur Vorbehandlung von Wafern Prozessschritte wie Nassreinigung, Plasmabehandlung, Ätzen oder Heizen in Frage, während für die Hauptbehandlung eines Wafers Bonden, Belacken, Imprinten, Embossing und Belichtung in Frage kommen. Bei bekannten Prozessanlagen werden die Wafer oder Waferstapel mit Kassetten zwischen den Prozessanlagen oder Modulen von Prozessanlagen transportiert.

Die US 5,455,082 A offenbart eine Schleusenanlage zum Ätzen von Substraten, die JP 2001 351892 A eine Schleusenanlage zum Bonden von Substratpaaren.

Während des Transports kann es zur Kontamination, Beschädigung, Verunreinigung oder Oxidation und damit zur Beeinflussung weiterer Prozessschritte kommen.

Auch eine Kontamination der Hauptbehandlungskammer zwischen den Behandlungen aufeinanderfolgender Wafer, also beim Be- und Entladen der Wafer, ist problematisch.

Weiterhin ist es in zeitlicher Hinsicht kritisch, dass bei der Hauptbehandlung große Druckdifferenzen von Atmosphärendruck bis hin zu sehr niedrigeren Drücken von 10⁻⁶ bar oder weniger überwunden werden müssen.

Aufgabe der vorliegenden Erfindung ist es daher, die Prozessierung von Substraten sowohl vom Ablauf her zu optimieren, als auch eine Kontamination, Beschädigung, Verunreinigung oder Oxidation möglichst zu vermeiden.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zu Grunde, ein Hauptbehandlungsmodul mit mindestens einem Vorbehandlungsmodul und mindestens einem Nachbehandlungsmodul derart zu koppeln, dass das Hauptbehandlungsmodul jeweils als vakuumdichte Schleuse für ein benachbartes Vorbehandlungs-, Hauptbehandlungs- oder Nachbehandlungsmodul wirkt. Gleichzeitig ist es erfindungsgemäß in einer Ausführungsform der Erfindung vorgesehen, dass mindestens eines der Vorbehandlungsmodule und/oder das Hauptbehandlungsmodul und/oder mindestens eines der Nachbehandlungsmodule eigenständig beziehungsweise unabhängig von einem benachbarten Modul temperierbar, insbesondere beheizbar, ist.

Auf diese Weise wird trotz eines flexiblen Aufbaus der Prozessanlage gemäß der erfindungsgemäßen Vorrichtung eine zeitlich optimierte, sogar parallele, Prozessierung von mehreren Substraten innerhalb der erfindungsgemäßen Vorrichtung vorgesehen, bei der auf Grund der schleusenartigen Kupplung der einzelnen Prozessmodule eine Kontamination, Beschädigung, Verunreinigung oder Oxidation durch Entkopplung der Substrate von Außeneinflüssen, insbesondere beim Be- und Entladen der einzelnen Module, gelöst wird.

Besonders vorteilhaft ist es, wenn das Hauptbehandlungsmodul ausschließlich über Schleusen be- und entladbar ist. Dies wird erfindungsgemäß gelöst, indem sowohl ein mit dem Hauptbehandlungsmodul schleusenartig gekoppeltes Vorbehandlungsmodul als auch ein mit dem Hauptbehandlungsmodul schleusenartig gekoppeltes Nachbehandlungsmodul vorgesehen ist. Durch diese Maßnahme findet die meist besonders kritische und unter oft extremen Bedingungen stattfindende Hauptbehandlung der Substrate beziehungsweise Wafer zu keinem Zeitpunkt der Prozessierung und auch nicht während des Be- und Entladens des Hauptbehandlungsmoduls mit Kontakt zur Umgebung statt. Das Hauptbehandlungsmodul ist demnach vollständig von der Umgebung entkoppelt, so dass eine Kontamination, Beschädigung, Verunreinigung oder Oxidation während der Hauptbehandlung der Substrate praktisch ausgeschlossen ist. Weiterhin besteht der Vorteil, dass die Hauptbehandlung vor- und nachbereitende Schritte in das Vorbehandlungs- und das Nachbehandlungsmodul ausgelagert werden können, insbesondere eine zumindest teilweise Druck- und/oder Temperaturbeaufschlagung. Im Hauptbehandlungsmodul ist in Folge dessen nur eine geringere Druck- und/oder Temperaturdifferenz zu überwinden als vom Umgebungs-/Atmosphärendruck p_{ATM}.

Gemäß einer vorteilhaften Ausführungsform der Erfindung ist vorgesehen, dass die Hauptbehandlungskammer beim Be- und Entladen der Substrate als Schleuse schaltbar ist. Somit kann beim Beladen der Hauptbehandlungskammer gleichzeitig eine Nachbehandlung des vorher in der Hauptbehandlungskammer bearbeiteten Substrats erfolgen. Beim Entladen der Hauptbehandlungskammer kann dagegen gleichzeitig eine Vorbehandlung des nächsten, in der Hauptbehandlungskammer zu bearbeitenden Substrats in der Vorbehandlungskammer erfolgen.

In einer weiteren, vorteilhaften Ausführungsform ist vorgesehen, dass die Vorbehandlungskammer und/oder die Hauptbehandlungskammer und/oder die Nachbehandlungskammer, insbesondere separat, mittels einer Heizeinrichtung heizbar sind. Besonders vorteilhaft ist es dabei, wenn die Vorbehandlungskammer und/oder die Hauptbehandlungskammer und/oder die Nachbehandlungskammer vollständig wärmegedämmt sind. Auf diese Weise ist eine genaue Temperatursteuerung bei geringst möglichem Wärmeverlust möglich.

Soweit dem Vorbehandlungsmodul weitere, korrespondierend ausgebildete Vorbehandlungsmodule als Schleusen vorschaltbar sind und/oder dem Nachbehandlungsmodul weitere, korrespondierend ausgebildete Nachbehandlungsmodule als Schleusen nachschaltbar sind, kann der Verfahrensablauf weiter unterteilt werden, so dass sich eine Optimierung der Durchlaufzeiten im Prozessablauf ergibt. Dabei ist es erfindungsgemäß denkbar, dass mit einem Vorbehandlungsmodul gleichzeitig mehrere Vorbehandlungsmodule über Schleusentore direkt gekoppelt sind. Auf diese Weise können zeitintensive Vorbehandlungsschritte parallel und entsprechend zeitversetzt in den vorgeschalteten Vorbehandlungsmodulen ablaufen. Dies gilt analog für korrespondierende Nachbehandlungsmodule.

Indem die Schleusen als Druck- und/oder Temperaturschleusen ausgebildet sind, ist es erfindungsgemäß möglich, den Druck und/oder die Temperatur durch entsprechende Schaltung der Vorbehandlungsmodule und/oder der Nachbehandlungsmodule zu steuern.

Zum Be- und Entladen ist erfindungsgemäß eine Be- und Entladeeinrichtung, insbesondere mindestens ein Roboterarm, vorgesehen. Dieser wird zum Be- und Entladen der Substrate in die/aus der Hauptbehandlungskammer und/oder der Vorbehandlungskammer und/oder der Nachbehandlungskammer eingesetzt, wobei zur parallelen Handhabung mehrere, im Prozessablauf befindliche Substrate/Wafer erfindungsgemäß mehrere Roboterarme vorgesehen sein können. So kann beispielsweise in jeder Vorbehandlungskammer und/oder jeder Nachbehandlungskammer genau ein Roboterarm vorgesehen sein, der in die jeweils benachbarte Vorbehandlungs- oder Hauptbehandlungskammer zu Be- und Entladen der jeweils benachbarten Kammern eingreifen kann, wenn das jeweilige Schleusentor geöffnet ist.

Gemäß einer besonders vorteilhaften Ausführungsform ist vorgesehen, dass die Hauptbehandlungskammer gleichzeitig von der Vorbehandlungskammer be- und in die Nachbehandlungskammer entladbar ist und/oder die Vorbehandlungskammer und die Nachbehandlungskammer gleichzeitig über das erste Schleusentor be- und über das zweite Schleusentor entladbar sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1a: eine schematische Aufsicht auf eine erfindungsgemäße Vorrichtung mit einem Vorbehandlungsmodul, einem Hauptbehandlungsmodul und einem Nachbehandlungsmodul,
- Fig. 1b: eine schematische Schnittansicht der erfindungsgemäßen Vorrichtung gemäß Schnittlinie A-A aus Figur 1a,
- Fig. 2a: eine schematische Aufsicht auf eine zweite Ausführungsform der erfindungsgemäßen Vorrichtung mit einem Vorbehandlungsmodul, einem Hauptbehandlungsmodul und einem Nachbehandlungsmodul,
- Fig. 2b: eine schematische Schnittansicht der erfindungsgemäßen Vorrichtung gemäß Schnittlinie A-A aus Figur 2a,
- Fig. 2c: eine schematische Schnittansicht der erfindungsgemäßen Vorrichtung gemäß Schnittlinie B-B aus Figur 2a,
- Fig. 3: ein Druck-/Temperaturdiagramm eines erfindungsgemäßen Verfahrens zur Prozessierung von Substraten und
- Fig. 4: eine Schnittansicht der erfindungsgemäßen Vorrichtung mit einem Vorbehandlungsmodul, einem Hauptbehandlungsmodul und einem Nachbehandlungsmodul.

In den Figuren sind gleiche Bezugszeichen für korrespondierende Bauteile vorgesehen.

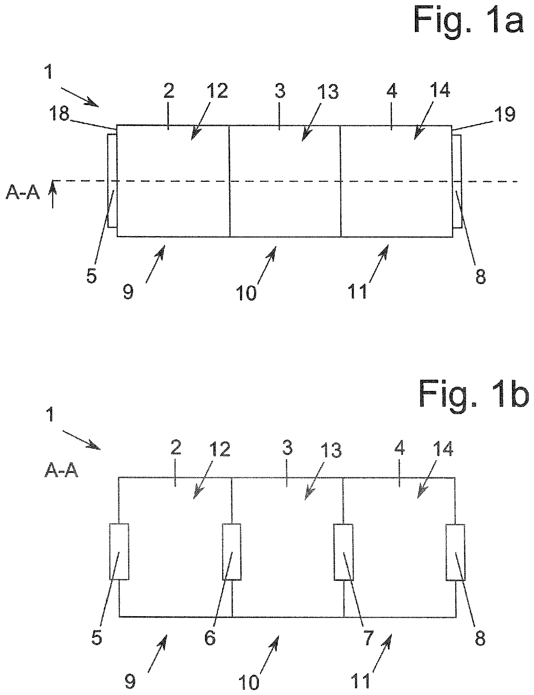

In der in Figur 1 gezeigten Ausführungsform einer erfindungsgemäßen Vorrichtung 1 sind ein Vorbehandlungsmodul 9, ein Hauptbehandlungsmodul 10 und ein Nachbehandlungsmodul 11 linear in Reihe angeordnet.

Das Vorbehandlungsmodul 9 besteht aus einer mit Vakuum beaufschlagbaren Vorbehandlungskammer 2, die einen Vorbehandlungsraum 12 umschließt. An die Vorbehandlungskammer 2 ist eine nicht dargestellte Druckbeaufschlagungseinrichtung angeschlossen, die von einer nicht dargestellten zentralen Steuereinrichtung steuerbar ist, um den Druck in dem Vorbehandlungsraum 12 bei geschlossener Vorbehandlungskammer 2 steuern zu können. Über eine nicht dargestellte Temperaturbeaufschlagungseinrichtung ist der Vorbehandlungsraum 12 heizbar und/oder kühlbar, wobei die Temperaturbeaufschlagungseinrichtung von der zentralen Steuereinrichtung steuerbar ist.

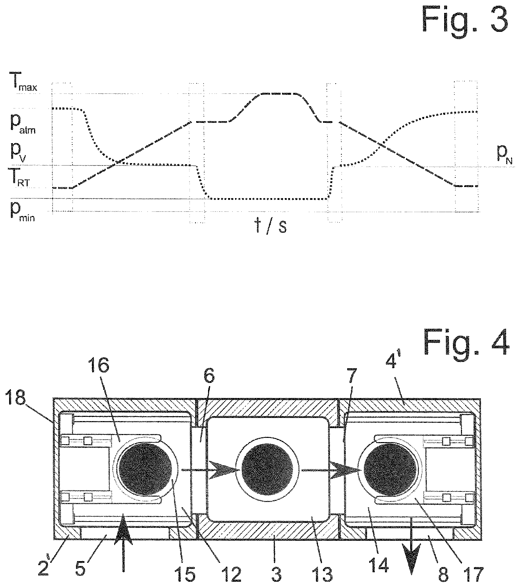

Zum Beladen des Vorbehandlungsmoduls 9 mit einem (oder mehreren) Wafer 15 ist gemäß Figur 4 ein erster Roboterarm 16 vorgesehen. Dieser ist - gesteuert von der zentralen Steuereinrichtung - durch ein erstes Schleusentor 5 hindurchführbar, wenn das erste Schleusentor 5 geöffnet ist. Das Öffnen und Schließen des ersten Schleusentors 5 wird ebenfalls durch die zentrale Steuereinrichtung gesteuert.

Das erste Schleusentor 5 ist in der Ausführungsform gemäß Figur 1a und 1b an einer ersten Stirnseite 18 der Vorrichtung 1 angeordnet. Das erste Schleusentor 5 ist druckdicht verschließbar und weist eine Wärmedämmung auf, damit der Vorbehandlungsraum 12 im geschlossenen Zustand des ersten Schleusentors 5 unter Druck gesetzt werden kann.

Weiterhin weist die Vorbehandlungskammer 2 gegenüberliegend zum ersten Schleusentor 5 gemeinsam mit einer Hauptbehandlungskammer 3 des Hauptbehandlungsmoduls 10 ein erstes Hauptschleusentor 6 auf. Das erste Hauptschleusentor 6 ist funktional analog dem ersten Schleusentor 5 ausgebildet. Das Hauptbehandlungsmodul 10 ist am ersten Hauptschleusentor 6 mit dem Vorbehandlungsmodul 9 druckdicht koppelbar, wodurch ein modulartiger Aufbau und ein Austausch einzelner Module 9, 10, 11 der Vorrichtung 1 realisierbar sind.

Durch Steuerung des ersten Schleusentors 5 und des ersten Hauptschleusentors 6 mittels der zentralen Steuereinrichtung ist das Vorbehandlungsmodul 9 als Schleuse einsetzbar, nämlich indem bei geöffnetem ersten Schleusentor 6 das erste Schleusentor 5 geschlossen ist und umgekehrt.

Das Hauptbehandlungsmodul 10 besteht aus der Hauptbehandlungskammer 3, die einen Hauptbehandlungsraum 13 umschließt beziehungsweise bildet.

Gegenüberliegend zum ersten Hauptschleusentor 6 der Hauptbehandlungskammer 3 ist ein zumindest teilweise zur Hauptbehandlungskammer 3 zählendes zweites Hauptschleusentor 7 vorgesehen, das zum Entladen des Wafers 15 von der Hauptbehandlungskammer 3 in eine Nachbehandlungskammer 4 dient. Das zweite Hauptschleusentor 7 ist zumindest teilweise von der Nachbehandlungskammer 4 gebildet. Der Hauptbehandlungsraum 13 ist durch das zweite Hauptschleusentor 7 von einem Nachbehandlungsraum 14 der Nachbehandlungskammer 4 druckdicht abdichtbar. Funktional entspricht das zweite Hauptschleusentor 7 dem ersten Hauptschleusentor 6, wobei das erste Hauptschleusentor 6 und das zweite Hauptschleusentor 7, gesteuert von der zentralen Steuereinrichtung, eine Schleuse bilden.

Das Nachbehandlungsmodul 11 zur Nachbehandlung des Wafers 15 nach der Hauptbehandlung in dem Hauptbehandlungsmodul 10 besteht aus der Nachbehandlungskammer 4, die den Nachbehandlungsraum 14 bildet. Weiterhin weist die Nachbehandlungskammer 4 ein zweites Schleusentor 8 auf, das dem zweiten Hauptschleusentor 7 gegenüberliegend angeordnet ist.

Über das zweite Schleusentor 8 und mittels eines zweiten Roboterarms 17 kann der Wafer 15 nach der Nachbehandlung aus dem Nachbehandlungsraum 14 entladen werden, sobald das zweite Schleusentor 8 geöffnet ist.

Das Nachbehandlungsmodul 11 kann ebenfalls als Schleuse wirken, indem das zweite Hauptschleusentor 7 geschlossen ist, wenn das zweite Schleusentor 8 geöffnet ist und umgekehrt.

Das zweite Schleusentor 8 ist an einer zweiten Stirnseite 19 der Vorrichtung 1 angeordnet, so dass eine lineare Bewegung des Wafers 15 während des gesamten Prozessablaufs durch das Vorbehandlungsmodul 9, das Hauptbehandlungsmodul 10 und das Nachbehandlungsmodul 11 hindurch erfolgt.

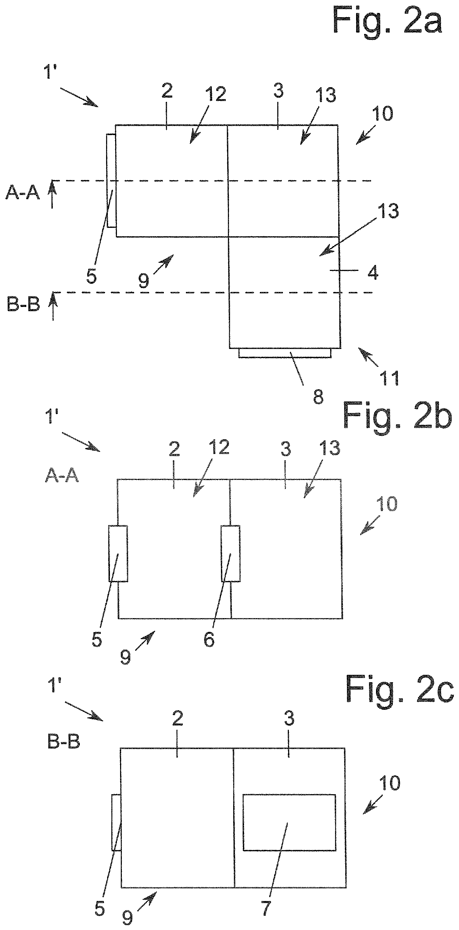

Die Ausführungsform gemäß Figur 2a unterscheidet sich durch winkelige Anordnung der Module 9, 10, 11, so dass sich eine geänderte Vorrichtung 1' ergibt. Geändert ist lediglich die Ausgestaltung der Hauptbehandlungskammer 3', da das zweite Hauptschleusentor 7 nicht gegenüberliegend zum ersten Hauptschleusentor 6 angeordnet ist, sondern an einer Seitenwand der Hauptbehandlungskammer 3'.

In einer weiteren Ausführungsform der Erfindung könnte in der Ausführungsform gemäß Figuren 1a und 1b ein zusätzliches Seitenmodul (nicht dargestellt) analog dem Nachbehandlungsmodul 11 in Figur 2a seitlich am Hauptbehandlungsmodul 10 angeordnet sein, um beschädigte Wafer, die während des Prozessflusses erkannt werden, aus dem Prozessablauf zu entfernen.

Ein erfindungsgemäßer Verfahrensablauf, dessen Druck- und Temperaturverlauf in Figur 3 dargestellt ist, läuft wie folgt ab:
Das erste Hauptschleusentor 6 und das zweite Hauptschleusentor 7 werden geschlossen. Danach wird der Druck im Hauptbehandlungsraum 13 durch eine nicht dargestellte Druckbeaufschlagungseinrichtung, beispielsweise eine Vakuumpumpe, abgesenkt, insbesondere auf einem Druck pₘᵢₙ kleiner 10⁻⁶ bar, vorzugsweise auf einen Druck kleiner 10⁻⁹ bar. Dies erfolgt idealerweise nur ein einziges Mal während der Prozessierung von einer Vielzahl, insbesondere mehr als 100, vorzugsweise mehr als 1000, noch bevorzugter mehr als 10000 Wafern oder Waferpaaren.

Über das geöffnete erste Schleusentor 5 wird ein Wafer 15 oder Waferpaar mittels des ersten Roboterarms 16 in die Vorbehandlungskammer geladen und dort behandelt. Bei der Vorbehandlung kann es sich um einen trockenen und/oder nassen Prozessschritt handeln, beispielsweise Nassreinigung, Plasmabehandlung, Ätzen, Heizen oder ähnliches. Besonders vorteilhaft umfasst die Vorbehandlung eine, insbesondere optische und/oder mechanische Ausrichtungseinrichtung.

Vor oder nach beziehungsweise während des Vorbehandlungsschritts kann der Vorbehandlungsraum 12 über eine separat ansteuerbare Druckbeaufschlagungseinrichtung evakuiert werden.

Vor dem Öffnen des ersten Hauptschleusentors 6 wird jedenfalls das erste Schleusentor 5 geschlossen und der Vorbehandlungsraum 12 evakuiert, insbesondere auf einem Druck pᵥ beim oder kurz vor dem Beladen der Hauptbehandlungskammer 3 von weniger als 10⁻⁶ bar, vorzugsweise weniger als 10⁻⁷ bar, so dass das Vorbehandlungsmodul 9 als Schleuse für das Hauptbehandlungsmodul 10 wirkt.

Durch ein internes Transportsystem, beispielsweise einen Roboterarm, wird der Wafer 15 durch das erste Hauptschleusentor 6 hindurch in die Hauptbehandlungskammer 3, 3' geladen.

Anschließend wird das erste Hauptschleusentor 6 geschlossen. Während des Beladens der Hauptbehandlungskammer 3, 3' ist das zweite Hauptschleusentor 7 ständig geschlossen. Der Druck wird vorzugsweise weiter abgesenkt auf pₘᵢₙ kleiner 10⁻⁶ bar, noch bevorzugter 10⁻⁹ bar.

Nach dem Schließen des ersten Hauptschleusentors 6 kann bereits ein weiterer Wafer 15 in die Vorbehandlungskammer 2 geladen werden. Gleichzeitig findet die Hauptbehandlung des ersten Wafers 15 im Hauptbehandlungsmodul 10 statt. Hierbei handelt es sich erfindungsgemäß um einen Bondprozess.

Nach der Hauptbehandlung des Wafers 15 im Hauptbehandlungsmodul 10 wird der Wafer 15 durch Öffnen des zweiten Hauptschleusentors 7 in das Nachbehandlungsmodul 11 geladen, wobei das zweite Schleusentor 8 geschlossen ist. Vor dem Öffnen des zweiten Hauptschleusentors 7 wird der Nachbehandlungsraum 14 durch eine Druckbeaufschlagungseinrichtung des Nachbehandlungsmoduls 11 mit Vakuum, insbesondere einem Druck p_{N} von weniger als 10⁻⁶, vorzugsweise weniger als 10⁻⁷, beaufschlagt, und zwar zumindest bis der Wafer 15 vom Hauptbehandlungsmodul 10 in das Nachbehandlungsmodul 11 geladen ist und das zweite Hauptschleusentor 7 wieder geschlossen ist.

Anschließend findet eine Nachbehandlung des Wafers 15 im Nachbehandlungsmodul 11 statt, beispielsweise eine Abkühlung und gleichzeitige Erhöhung des Drucks durch die Druckbeaufschlagungseinrichtung des Nachbehandlungsmoduls 11.

Nach Abschluss der Nachbehandlung des Wafers 15 im Nachbehandlungsmodul 11 wird der Wafer 15 über das zweite Schleusentor 8 und den zweiten Roboterarm 17 entnommen.

Vor jedem Öffnen des Hauptschleusentors 6 sind die Vorbehandlungskammer 2 und vor jedem Öffnen des Hauptschleusentors 7 die Nachbehandlungskammer 4 mit einem Druck p_{V} beziehungsweise p_{N} kleiner als der Atmosphären- oder Umgebungsdruck p_{ATM} außerhalb der Kammern 2, 3, 4 beaufschlagt und/oder dekontaminiert, insbesondere mit Inertgas gespült.

Erfindungsgemäß ist der Wafer 15 ein Waferpaar beziehungsweise wird ein Waferpaar mittels einer Halterung beziehungsweise Handhabungseinrichtung zur Handhabung des Waferpaars in die Vorrichtung 1 in der oben beschriebenen Art und Weise geladen, wobei die im linken Abschnitt in Figur 3 dargestellte Vorbehandlung die Schritte Aufheizen, Evakuieren,

Gasspülung mit reduzierenden Gasen, eine nasschemische Behandlung, eine Plasmabehandlung und/oder einen Argon-Beschuss umfasst.

Die Hauptbehandlung erfolgt bei einem im Vergleich zur Vorbehandlung höheren Vakuum, also niedrigerem Druck pₘᵢₙ, wie es in Figur 3 im mittleren Abschnitt dargestellt ist. Durch die Druckbeaufschlagungseinrichtung des Hauptbehandlungsmoduls 10 wird dabei eine kontrollierte Gasatmosphäre, also ein genau eingestellter Gasdruck sowie ein genau kontrolliertes Mischungsverhältnis von Gasen eingestellt. Dann wird das Waferpaar in Kontakt gebracht und gebondet. Davor wird die für die Verbindung nötige Temperatur, insbesondere Tₘₐₓ größer als 250°C, vorzugsweise Tₘₐₓ größer als 400 °C, eingestellt. Beim Bonden wird eine möglichst gleichmäßige Kraft auf das Waferpaar aufgebracht und/oder eine elektrische Spannung angelegt.

Die Nachbehandlung, die in Figur 3 im rechten Abschnitt dargestellt ist, erfolgt in einer nicht oxidierenden Umgebung, bei der eine Abkühlung erfolgt und eine Anhebung des Drucks auf Atmosphärendruck. Eine langsame Kühlung verhindert oder vermeidet thermische Spannungen im vorher gebondeten Waferpaar.

Die Vorbehandlung des Waferpaars kann gemäß einer Ausführungsform derart erfolgen, dass ein erstes Vorbehandlungsmodul für eine Vorbehandlung des ersten Wafers oder Waferpaares und ein zweites Vorbehandlungsmodul für eine Vorbehandlung des zweiten Wafers oder Waferpaars vorgesehen ist. Der erste und der zweite Wafer sind über separate Schleusentore in die Hauptbehandlungskammer ladbar.

Die Kammern 2, 3, 4 sind vorzugsweise aus rostfreiem Stahl oder Aluminium gefertigt.

Bei der in Figur 4 gezeigten Ausführungsform ist das erste Schleusentor 5 nicht an der Stirnseite 18 der Vorbehandlungskammer 2', sondern an der Seitenwand angeordnet. Das zweite Schleusentor 8 ist nicht an der Stirnseite 19, sondern an der Seitenwand der Nachbehandlungskammer 4' angeordnet.

Der Prozessfluss ist durch Pfeile in Figur 4 dargestellt.

Die Hauptschleusentore 6, 7 müssen entsprechend hohe Druckdichtigkeit bis pₘᵢₙ aufweisen und sind vorzugsweise als Transferventil ausgebildet, das in einem gemeinsamen Kanal zwischen den jeweils benachbarten Kammern 2, 3, 4 dichtend eingesetzt beziehungsweise einsetzbar ist. Der Öffnungsdurchmesser der Schleusentore 5, 6, 7, 8 beträgt mehr als 200mm, insbesondere mehr als 300mm, vorzugsweise mehr als 450mm.

### Bezugszeichenliste

- 1, 1': Vorrichtung
- 2, 2': Vorbehandlungskammer
- 3, 3': Hauptbehandlungskammer
- 4, 4': Nachbehandlungskammer
- 5: erstes Schleusentor
- 6: erstes Hauptschleusentor
- 7: zweites Hauptschleusentor
- 8: zweites Schleusentor
- 9: Vorbehandlungsmodul
- 10: Hauptbehandlungsmodul
- 11: Nachbehandlungsmodul
- 12: Vorbehandlungsraum
- 13: Hauptbehandlungsraum
- 14: Nachbehandlungsraum
- 15: Wafer
- 16: erster Roboterarm
- 17: zweiter Roboterarm
- 18: erste Stirnseite
- 19: zweite Stirnseite

## Patentansprüche

1. Vorrichtung zum Bonden von Substratpaaren mit mindestens einem zur Nassreinigung, Plasmabehandlung, zum Ätzen und/oder Heizen ausgebildeten Vorbehandlungsmodul (9) und mindestens einem Nachbehandlungsmodul (11), die mit einem zum Bonden ausgebildeten Hauptbehandlungsmodul (10) derart gekoppelt sind, dass das Hauptbehandlungsmodul (10) als vakuumdichte Schleuse für das benachbarte Vorbehandlungsmodul (9) und/oder das Nachbehandlungsmodul (11) ausgebildet ist.

2. Vorrichtung nach Anspruch 1, wobei eine Hauptbehandlungskammer (3) des Hauptbehandlungsmoduls (10) beim Be- und Entladen der Substrate als Schleuse schaltbar ist.

3. Vorrichtung nach einem der vorhergehenden Ansprüche, bei der die Vorbehandlungskammer (2) und/oder die Hauptbehandlungskammer (3) und/oder die Nachbehandlungskammer (4), insbesondere separat, mittels einer Temperaturbeaufschlagungseinrichtung heizbar und/oder kühlbar sind.

4. Vorrichtung nach einem der vorhergehenden Ansprüche, bei der dem Vorbehandlungsmodul (9) weitere, korrespondierend ausgebildete, Vorbehandlungsmodule als Schleusen vorschaltbar sind und/oder dem Nachbehandlungsmodul (11) weitere, korrespondierend ausgebildete, Nachbehandlungsmodule als Schleusen nachschaltbar sind.

5. Vorrichtung nach einem der vorhergehenden Ansprüche, bei der die Schleusen als Druck- und/oder Temperaturschleusen ausgebildet sind.

6. Vorrichtung nach einem der vorhergehenden Ansprüche, bei der eine Be- und Entladeeinrichtung, insbesondere mindestens ein Roboterarm (16, 17), zum Be- und Entladen der Substratpaare in die/aus der Vorbehandlungskammer (2) und/oder der Nachbehandlungskammer (4) vorgesehen ist.

## Claims

1. A device for bonding substrates pairs with at least one pre-treatment module (9) designed for wet cleaning, plasma treatment, etching and/or heating and at least one post-treatment module (11), which are coupled with a main treatment module (10) designed for bonding, in such a way that the main treatment module (10) is constituted as a vacuum-tight lock for the adjacent pre-treatment module (9) and/or the post-treatment module (11).

2. The device according to claim 1, wherein a main treatment chamber (3) of the main treatment module (10) can be switched as a lock during the loading and unloading of the substrates.

3. The device according to any one of the preceding claims, wherein the pre-treatment chamber (2) and/or the main treatment chamber (3) and/or the post-treatment chamber (4) can be heated and/or cooled, in particular separately, by means of a temperature exposure device.

4. The device according to any one of the preceding claims, wherein further, correspondingly designed, pre-treatment modules can be arranged as locks upstream of the pre-treatment module (9) and/or further, correspondingly designed, post-treatment modules can be arranged as locks downstream of the post-treatment module (11).

5. The device according to any one of the preceding claims, wherein the locks are constituted as pressure and/or temperature locks.

6. The device according to any one of the preceding claims, wherein a loading and unloading device, in particular at least one robot arm (16, 17), is provided for the loading and unloading of the substrate pairs into the and/or out of the pre-treatment chamber (2) and/or the post-treatment chamber (4).

## Revendications

1. Dispositif pour la liaison de paires de substrats comprenant au moins un module de pré-traitement (9) formé pour le nettoyage par voie humide, le traitement plasma, la gravure et/ou le chauffage et au moins un module de post-traitement (11) qui sont ainsi couplés à un module de traitement principal (10) formé pour la liaison que le module de traitement principal (10) est formé en tant que sas étanche au vide pour le module de pré-traitement (9) et/ou le module de post-traitement (11) voisin.

2. Dispositif selon la revendication 1, dans lequel une chambre de traitement principal (3) du module de traitement principal (10) peut être commutée en tant que sas lors du chargement et déchargement des substrats.

3. Dispositif selon l'une des revendications précédentes, dans lequel la chambre de pré-traitement (2) et/ou la chambre de traitement principal (3) et/ou la chambre de post-traitement (4) peuvent être chauffées et/ou refroidies en particulier séparément, au moyen d'un dispositif de sollicitation en température.

4. Dispositif selon l'une des revendications précédentes, dans lequel d'autres modules de pré-traitement formés de manière correspondante peuvent être branchés en tant que sas en amont du module de pré-traitement (9) et ou d'autres modules de post-traitement formés de manière correspondante peuvent être branchés en tant que sas en aval du module de post-traitement (11).

5. Dispositif selon l'une des revendications précédentes, dans lequel les sas sont conçus en tant que sas sous pression et/ou température.

6. Dispositif selon l'une des revendications précédentes, dans lequel un dispositif de chargement et déchargement, en particulier au moins un bras de robot (16, 17) est prévu pour charger et décharger la paire de substrats dans les/hors des chambre de pré-traitement (2) et/ou chambre de post-traitement (4).
